# EUROPÄISCHE PATENTSCHRIFT

(11) **EP 0 864 805 B1**
(45) Veröffentlichungstag und Bekanntmachung des Hinweises auf die Patenterteilung: **20.10.2004**
(21) Anmeldenummer: 98104438.1
(22) Anmeldetag: 12.03.1998
(51) Int. Cl.: F21V 31/03, H05K 5/02, F21W 101/10

(54) **Gehäuse, insbesondere eines Fahrzeugscheinwerfers**
Housing, in particular for vehicle headlights
Boîtier, notamment pour projecteurs de véhicule

(30) Priorität: 15.03.1997 DE 19710822
(43) Veröffentlichungstag der Anmeldung: 16.09.1998
(73) Patentinhaber: Hella KG Hueck & Co., 59552 Lippstadt (DE)
(72) Erfinder: Kalwa, Matthias, Dr., 59555 Lippstadt (DE); Wystrach, Dieter, 59558 Lippstadt (DE)

(56) Entgegenhaltungen:
- EP-A- 0 317 896
- EP-A- 0 587 502
- FR-A- 2 589 996
- OSTREM F E: "COMBINED AIR VENT AND WATER SEAL VALVE FOR AUTOMOTIVE ELECTRONIC MODULES" MOTOROLA TECHNICAL DEVELOPMENTS, Bd. 10, 1. März 1990 (1990-03-01), Seite 117 XP000114679

## Beschreibung

Die Erfindung betrifft ein Gehäuse nach dem Oberbegriff des Patenanspruchs 1.

Die Erfindung betrifft weiterhin ein Verfahren zur Durchlüftung eines Gehäuseinnenraumes eines Gehäuses, insbesondere eines Fahrzeugscheinwerfers, bei dem in den Gehäuseinnenraum über mindestens eine Lufteintrittsöffnung Luft eintritt und über mindestens eine Luftaustrittsöffnung Luft austritt.

Durchlüftete Gehäuse, wie sie beispielsweise aus der DE 33 28 788 A1 und der DE 30 04 413 C2 bekannt sind, zeichnen sich dadurch aus, dass mindestens zwei Öffnungen mit für Niederdruck Gasströmungen relevanten Querschnitten vorhanden sind.

Diese Öffnungen sind im allgemeinen so positioniert, dass sich bei stationärer Umströmung mit Luft (z.B. Fahrtwind bei konstanter Geschwindigkeit eines Fahrzeugs bzw. wetterbedingter Wind) eine Durchströmung des Geräteinneren einstellt. Bei belüfteten Systemen findet dagegen ein Luft- bzw. Gasmassenaustausch nicht bei einer stationären Umströmung statt, sondern nur bei zeitlichen Druckveränderungen (z. B. durch Druckstöße durch Änderung der Umströmungsgeschwindigkeit). Während bei durchlüfteten Gehäusen durchaus Volumenströme von einzelnen bis mehreren zig Litern pro Stunde gemessen werden, findet man bei nur belüfteten Gehäusen Nettodurchsätze, die (wegen der eigentlich nur schwingenden Luft- bzw. Gassäule) um ein bis drei Größenordnungen niedriger liegen. Folge der unterschiedlichen Durchsätze ist, dass im gleichen Maße unterschiedliche Schadstoffmengen in solche Gehäuse über die Umgebungsluft eingeschleppt werden. So können Schadstoffe, die einerseits korrosiv wirken (z. B. auf Reflektorbeschichtungen etc.) und andererseits durch Bildung sichtbarer Beläge dekorativ nachteilig wirken, eingetragen werden. Vorteil der durchlüfteten Gehäuse ist, dass eine dekorativ störende, sichtbare Wasser-Betauung wegen des höheren Luftdurchsatzes wesentlich schneller abtrocknen kann (Enttauung), als dies bei belüfteten Gehäusen der Fall ist. Nachteilig bei durchlüfteten Gehäusen ist, dass sich in akuten Betauungssituationen im allgemeinen schneller und mehr Kondensat im Gehäuseinnenraum bildet als bei belüfteten Gehäusen.

Um das Verhältnis zwischen Verschmutzung und Enttauung günstig zu beeinflussen, ist der Einsatz von Filtern bekannt. Diese Filter müssen allerdings so beschaffen sein, dass sie dem Durchlüftungs-Volumenstrom nur einen geringen Widerstand entgegensetzen, da die verfügbare Druckdifferenz zwischen den Durchlüftungsöffnungen sehr gering ist. Klein bauende Filter müssen daher zwangsläufig relativ grobporig sein, so dass feinste Schadstoffe (z. B. Aerosole) nur bedingt ausgefiltert werden können. Der Einsatz entsprechender feinporiger Filter würde sehr große Filterquerschnitte voraussetzen, um den für eine ausreichend schnelle Enttauung benötigten Volumenstrom zu erhalten.

Aus der FR-A-2 589 996 ist ein Gehäuse mit einer Durchlüftung eines Gehäuseinnenraumes über eine Öffnung für den Eintritt und/oder Austritt von Luftströmungen bekannt. In Abhängigkeit von der Luftfeuchte schließt oder öffnet ein in der Öffnung angeordnetes Schaltelement. Die Bewegung des Schaltelementes erfolgt lediglich in Abhängigkeit von einer Innenfeuchtigkeit des Gehäuseinnenraumes.

Aufgabe der vorliegenden Erfindung ist es daher, Gehäuse mit Durchlüftung des Gehäuseinnenraumes so zu verbessern, dass der Gesamt-Schadstoffeintrag reduziert wird und eine eventuelle Betauung schnell abtrocknen kann.

Die Aufgabe wird erfindungsgemäß durch die Merkmale des Patentanspruchs 1 gelöst.

Nach der Erfindung weist das Gehäuse ein Schaltelement auf, das in Abhängigkeit eines Differenzwertes aus der Innenfeuchtigkeit des Gehäuseinnenraumes und aus einer Außenfeuchtigkeit des außerhalb des Gehäuseinnenraumes liegenden Außenraumes den Strömungsquerschnitt mit mindestens einer der Öffnungen verändert. Damit wird der Strömungsquerschnitt nur dann freigegeben bzw. vergrößert, wenn die Innenfeuchtigkeit größer ist als die Außenfeuchtigkeit. Dadurch kann vorteilhaft erreicht werden, dass dem Gehäuse keine unerwünschte Außenfeuchtigkeit zugeführt wird. Die Durchlüftung des Gehäuses wird durch das Schaltelement sozusagen in eine Belüftung mit entsprechend niedrigem Schadstoffeintrag umgeschaltet.

Nach einer weiteren bevorzugten Ausführungsform der Erfindung ist das Schaltelement als eine den Querschnitt verändernde Zunge ausgebildet, die aus zwei durch eine Diffusionssperre voneinander getrennten Lagen mit ausgeprägten Feuchte-Dehneigenschaften so aufgebaut ist, dass eine Differenz zwischen Innenfeuchtigkeit und Außenfeuchtigkeit zu einer Biegeverformung führt, die den Querschnitt freigibt. Hier lässt sich ebenfalls durch eine gezielte Werkstoffauswahl eine Temperaturcharakteristik der Feuchte-Schaltcharakteristik überlagern.

Als Werkstoffe mit ausgeprägtem Feuchte-Dehnverhalten können vor allem solche organische Werkstoffe genutzt werden, die Feuchtigkeit bis zu einem Sättigungszustand, der mit der angebotenen Feuchtigkeitskonzentration der Umgebung korreliert, aufnehmen, wobei die Feuchtigkeitsaufnahme mit Quellvorgängen verbunden ist, die sich makroskopisch als Dimensionsänderung bemerkbar machen. Um eine diffusionsbedingte Zeitverzögerung des Schaltvorganges möglichst klein zu halten, werden Werkstoffe mit großem Oberflächen/Volumenverhältnis eingesetzt. Es eignen sich daher besonders dünne Folien oder poröse, offenzellige Gebilde (Schäume). Beispielsweise wird als Werkstoff Polyamidfolie verwendet.

Nach einer anderen bevorzugten Ausführungsform der Erfindung ist das Schaltelement als ein den Querschnitt verschließbares Folienstück mit ausgeprägten Feuchte-Dehneigenschaften und einer mindestens einer ausgeschnittenen Zunge ausgebildet, das auf einer Seite eine Gitterfolie aufweist und so aufgebaut ist, dass eine Differenz zwischen Innenfeuchtigkeit und Außenfeuchtigkeit zu einer Biegeverformung der I der Zunge bzw. einer Vielzahl von Zungen in Richtung der der Gitterfolie abgewandten Seite führt und einen der Zungenkontur entsprechenden Strömungsquerschnitt freigibt. Diese Ausführungsform ist besonders einfach und preisgünstig zu realisieren.

Gemäß einer weiteren bevorzugten Ausführungsform der Erfindung ist die Lufteintrittsöffnung durch ein erstes Schaltelement in Abhängigkeit des Differenzwertes aus der Innenfeuchtigkeit und der Außenfeuchtigkeit schaltbar und die Luftaustrittsöffnung ist durch ein zweites Schaltelement in Abhängigkeit von der Innenfeuchtigkeit schaltbar. Dadurch ist es auf einfache Weise möglich, in Abhängigkeit von Innenfeuchtigkeit und Außenfeuchtigkeit von einer Durchlüftung auf eine Belüftung und umgekehrt umzuschalten.

Nachteilig bei dem bekannten Verfahren zur Durchlüftung eines Gehäuseinnenraumes ist, daß bei einem hohen Luftdurchsatz bzw. einem hohen Volumenstrom auch ein hoher Schadstoffeintrag besteht. Eine Durchlüftung erfolgt in Abhängigkeit von einer Fahrzeugumströmung mit Luft und führt somit zu einer fast ständigen Durchlüftung mit einem entsprechenden Schadstoffeintrag. Eine Durchlüftung erfolgt auch dann, wenn die Außenfeuchtigkeit höher ist als die Innenfeuchtigkeit, so daß unerwünschte Feuchtigkeit in das Gehäuseinnere eingebracht wird.

Weitere Aufgabe der Erfindung ist es daher, ein Verfahren zur Durchlüftung eines Gehäuseinnenraumes so zu verbessern, daß der Schadstoffeintrag verringert und das Einbringen von Außenluft mit größerer Feuchte als der Luft im Gehäuseinnenraum vermindert wird.

Diese Aufgabe wird erfindungsgemäß dadurch gelöst, daß eine Durchlüftung nur dann erfolgt, wenn im Gehäuseinnenraum eine Betauung vorhanden ist und wenn die Feuchtigkeit der eintretenden Luft kleiner ist als die Feuchtigkeit der Luft im Gehäuseinnenraum.

Dadurch, daß die Durchlüftung in Abhängigkeit von der Außenfeuchtigkeit und der Innenfeuchtigkeit erfolgt, wird der Gesamt-Schadstoffeintrag deutlich reduziert. Das Gerät wird nur dann durchlüftet, wenn es notwendig und hinreichend sinnvoll ist. Die Durchlüftung ist nur dann notwendig, wenn im Gehäuseinnenraum eine Betauung vorhanden ist. Ist das Gehäuseinnere ausreichend trocken, reicht eine Belüftung aus. Hinreichend sinnvoll ist eine Durchlüftung nur dann, wenn die eintretende Außenluft überhaupt in ausreichendem Maße befähigt ist, Feuchtigkeit aufzunehmen und aus dem Geräteinneren heraus zu transportieren. Wenn eine vorhandene Betauung gar nicht beseitigt werden kann, erfolgt keine Durchlüftung und somit auch praktisch kein Schadstoffeintrag. Bei dieser geregelten Belüftung werden Schadstoffe nur in den im Vergleich zur Gesamtbetriebszeit relativ kurzen, gezielt erkannten Trocknungs- bzw. Enttauungsphasen in das Gerät eingetragen.

Gemäß einer bevorzugten Ausführungsform des Verfahrens wird ein Strömungsquerschnitt der Lufteintrittsöffnung durch ein Schaltelement in Abhängigkeit einer Differenz aus Außenfeuchtigkeit und Innenfeuchtigkeit der Luft verändert und ein Strömungsquerschnitt der Luftaustrittsöffnung wird durch ein Schaltelement in Abhängigkeit von der Innenfeuchtigkeit der Luft verändert. Dadurch ist es auf einfache Weise möglich, in Abhängigkeit von Außenfeuchtigkeit und Innenfeuchtigkeit der Luft die Durchlüftung zu regeln bzw. von einer Durchlüftung auf eine Belüftung umzuschalten.

Grundsätzlich kann ein erfindungsgemäßes Verfahren anstelle mit den vorher beschriebenen Schaltelementen auch mit elektronischen Schaltelementen durchgeführt werden. Die Schaltelemente können elektronische Feuchtesensoren, die den Feuchtegehalt von Gasen in Form eines proportionalen elektrischen Signals zur Verfügung stellen, aufweisen. Dieses Signal kann über eine Auswerteeinheit einem elektrischen Steller, der den Strömungsquerschnitt verändert, zugeführt werden.

Weitere Einzelheiten der Erfindung ergeben sich aus der nachfolgenden ausführlichen Beschreibung und den beigefügten Zeichnungen, in denen bevorzugte Ausführungsformen der Erfindung beispielhaft veranschaulicht sind.

In den Zeichnungen zeigen:
- Figur 1:: Eine schematische Darstellung eines Membran-Elementes in einer geschnittenen Seitenansicht,
- Figur 2:: eine räumliche Darstellung eines Schieberelementes im Schnitt,
- Figur 3:: eine schematische Seitenansicht eines als eine einen Querschnitt verändernde Zunge ausgebildeten Schaltelementes im Schnitt,
- Figur 4:: eine räumliche Darstellung eines als Zunge ausgebildeten Schaltelementes im trockenen Zustand,
- Figur 5:: eine räumliche Darstellung der Zunge von Figur 4 bei vorhandener Luftfeuchtigkeit,
- Figur 6:: eine räumliche Darstellung eines als Zunge ausgebildeten Schaltelementes mit zwei durch eine Diffusisionssperre voneinander getrennten Lagen mit Feuchte-Dehneigenschaften,
- Figur 7:: eine räumliche Gehäusedarstellung im Ausriß, teilweise im Schnitt mit der Zunge von Figur 6,
- Figur 8:: eine räumliche Darstellung eines als Folienstück mit einer Vielzahl von ausgeschnittenen Zungen und vorgelagerter Gitterfolie ausgebildeten Schaltelementes,
- Figur 9:: eine vergrößerte Darstellung einer Zunge von Figur 8 in einer geschnittenen Seitenansicht in vergrößerter Darstellung,
- Figur 10:: eine Draufsicht auf ein Folienstück mit ausgeschnittenen Zungen im Ausriß,
- Figur 11:: eine Draufsicht auf ein Folienstück mit ausgeschnittenen Zungen im Ausriß,
- Figur 12:: ein aus einer Stellfolie mit ausgeschnittener Zunge und einer vorgelagerten Gitterfolie ausgebildetes Schaltelement und
- Figur 13:: eine schematische Darstellung eines Fahrzeugscheinwerfergehäuses im Schnitt.

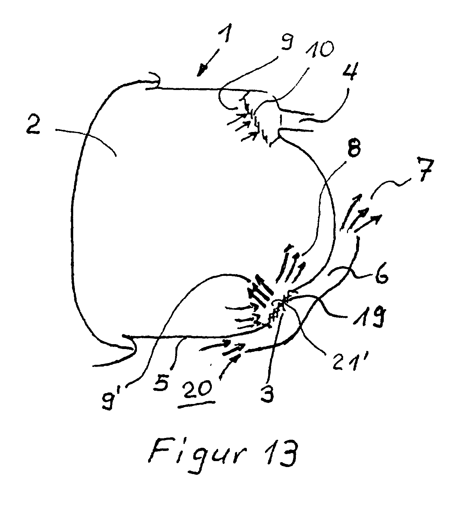

Ein Gehäuse (1), das beispielsweise als Scheinwerfergehäuse für Kraftfahrzeuge ausgebildet ist, besteht im wesentlichen aus einem Gehäuseinnenraum (2) mit einer Lufteintrittsöffnung (3) und einer Luftaustrittsöffnung (4), siehe Figur 13. An der dem Gehäuseinnenraum (2) abgewandten Außenseite (5) wird über einem Kamin (6) eine Außenluftzirkulation (7) an der Lufteintrittsöffnung (3) vorbeigeführt. Über die Lufteintrittsöffnung (3) in den Gehäuseinnenraum (2) eintretende Außenluft wird über eine Innenluftzirkulation (8) über die Luftaustrittsöffnung (4) aus dem Gehäuseinnenraum (2) wieder abgeführt. Der Luftaustrittsöffnung (4) ist zum Gehäuseinnenraum (2) hin ein einen Strömungsquerschnitt (9) in Abhängigkeit von der Luftfeuchte veränderndes erstes Schaltelement (10) vorgelagert, wobei das Schaltelement (10) bei höherer Luftfeuchtigkeit im Gehäuseinnenraum (2) den Querschnitt der Luftaustrittsöffnung (4) vergrößert und bei niedrigerer Luftfeuchtigkeit verringert.

Alternativ kann auch eine einzige große Luftöffnung vorgesehen sein, wobei durch die Kaminwirkung ein bereichsweiser Lufteintritt einerseits und ein bereichsweiser Luftaustritt andererseits ermöglicht wird.

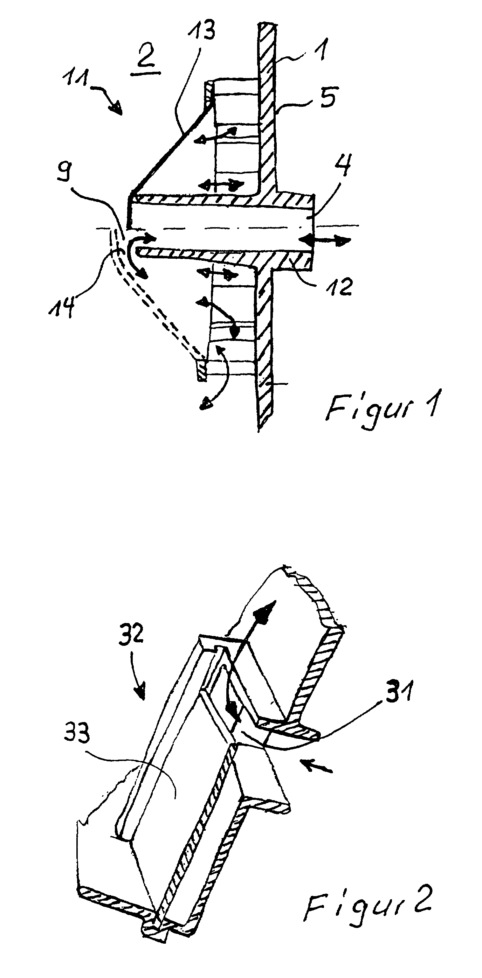

Nach einem ersten Ausführungsbeispiel gemäß Figur 1 ist das erste Schaltelement (10) als ein Membranelement (11) ausgebildet, das eine über ein Ende eines Rohres (12) gespannte Membran (13) aufweist, die sich durch die Aufnahme von Feuchtigkeit dehnt und einen Ringspalt (14) am Ende des Rohres (12) freigibt, so daß die feuchte Innenluft nach außen abgeführt werden kann.

Soll durch Feuchteaufnahme ein als Strömungsspalt (31) ausgebildeter Querschnitt geschlossen werden, kann anstelle eines Membranelementes (11) ein Schieberelement (32) gemäß Figur 2 eingesetzt werden. Ein Schieber (33) erfährt durch Aufnahme von Feuchtigkeit eine Dimensionsänderung, insbesondere in seiner Länge, so daß der Strömungsspalt (31) verschlossen wird.

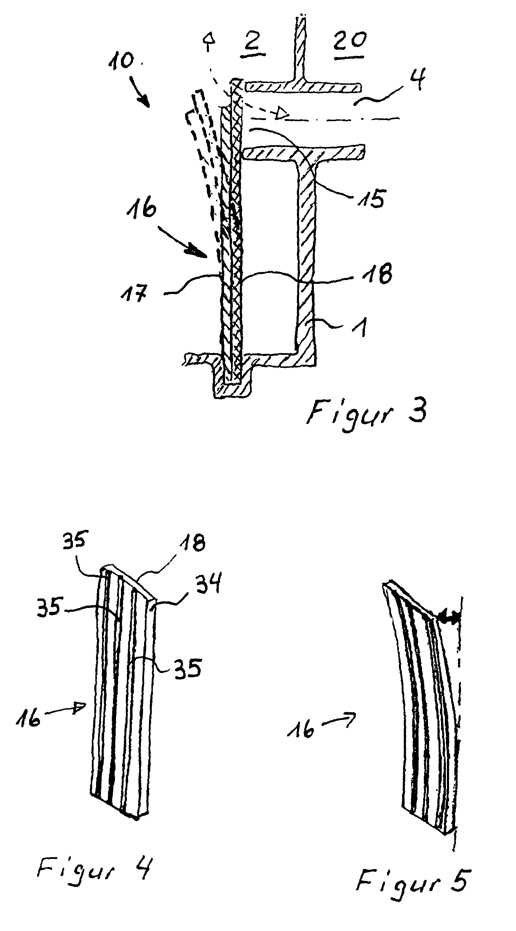

Nach einem weiteren Ausführungsbeispiel gemäß Figur 3 kann das erste Schaltelement (10) aber auch als eine einen Querschnitt (15) verändernde Zunge (16) ausgebildet sein.
Die Zunge (16) kann aus zwei unterschiedlichen Werkstoffen mit unterschiedlicher Feuchte-Dehnung bestehen und ist so aufgebaut, daß eine Feuchteaufnahme zu einer Biegeverformung führt, die den Querschnitt (15) freigibt. Die Zunge (16) weist an ihrer dem Querschnitt (15) abgewandten Rückseite (17) ein Material mit geringerer Feuchte-Dehneigenschaft auf. Auf ihrer der Rückseite (17) abgewandten Vorderseite (18) weist die Zunge (16) ein Material mit einer höheren Feuchte-Dehneigenschaft auf, so daß eine zu der im Gehäuseinnenraum (2) befindlichen Innenfeuchtigkeit proportionale Biegeverformung entsprechend Figur 5 erreicht wird, die den Querschnitt (15) freigibt.

Vorzugsweise weist die Zunge (16) auf ihrer Vorderseite (18) eine Polyamid-Folie (34) auf, und auf ihrer Rückseite (17) weist die Zunge (16) mit der Polyamid-Folie (34) verbundene Glasfasern (35) auf, siehe Figur 4. Figur 5 zeigt die Zunge (16) in einer Öffnungsposition, während sich die Zunge (16) gemäß Figur 4 in einer Schließposition befindet. Statt Glasfasern (35) können hier andere Stoffe eingesetzt werden, die z.B. einen ähnlichen Wärmeausdehnungskoeffizienten besitzen wie die Polyamid-Folie (34). Dann wäre nämlich die Verbiegung unabhängig von der Temperatur der Zunge (16).

Der Feuchte-Schaltcharakteristik kann also durch entsprechende Auswahl der Werkstoffe gezielt eine Temperatur-Schaltcharakteristik überlagert werden.

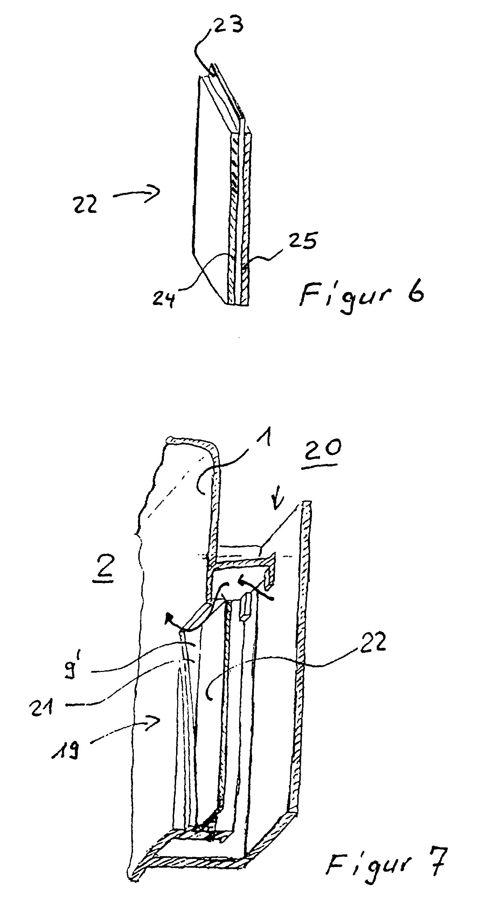

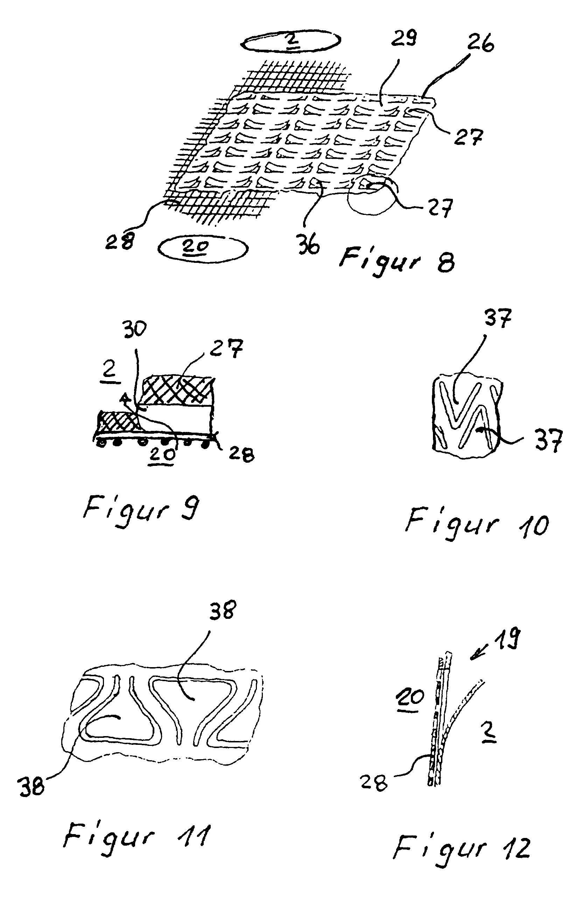

Der in Figur 13 dargestellten Lufteintrittsöffnung (3) ist zum Gehäuseinnenraum (2) hin ein zweites Schaltelement (19) vorgelagert. Der Strömungsquerschnitt (9') der Lufteintrittsöffnung (3) ist durch das zweite Schaltelement (19) in Abhängigkeit eines Differenzwertes aus der Innenfeuchtigkeit des Gehäuseinnenraumes (2) und der Außenfeuchtigkeit des außerhalb des Gehäuseinnenraum (2) liegenden Außenraumes (20) veränderbar. Wie aus Figur 6 und Figur 7 erkennbar, ist das zweite Schaltelement (19) als eine einen zweiten Querschnitt (21) verändernde zweite Zunge (22) ausgebildet. Die zweite Zunge (22) besteht aus zwei durch eine Diffusionssperre (23) voneinander getrennten Lagen (24,25) mit Feuchte-Dehneigenschaften, so daß eine Differenz zwischen Innenfeuchtigkeit und Außenfeuchtigkeit zu einer Biegeverformung führt, die den zweiten Querschnitt (21) freigibt. Die erste Lage (24) und die zweite Lage (25) können aus einem oder zwei verschiedenen Werkstoffen mit ausgeprägten Feuchte-Dehneigenschaften hergestellt sein. Die Diffusionssperre (23) besitzt einen hohen Diffusionwiderstand gegen Wasserdampf. Die Verbiegung dieser zweiten Zunge (22) korreliert in einem von der Werkstoffpaarung abhängigen Verhältnis mit der Differenz der relativen Feuchtegehalte der beiden Räume (2, 20).

Nach einem weiteren Ausführungsbeispiel gemäß Figur 8 kann das zweite Schaltelement (19) aber auch als ein einen zweiten Querschnitt (21') veränderndes einstückiges Folienstück (26) mit ausgeprägten Feuchte-Dehneigenschaften und einer Vielzahl von ausgeschnittenen Zungen (27) ausgebildet sein. Das Folienstück (26) weist auf seiner dem Innenraum (2) zugewandten Seite eine Gitterfolie (28) auf, so daß ein Aufbiegen der Zungen (27) in Richtung des Innenraumes (2) durch die Gitterfolie (28) verhindert wird. Die ausgeschnittenen Zungen (27) öffnen somit nur, wenn im Gehäuseinnenraum (2) ein höherer Feuchte-Gehalt vorhanden ist als im Außenraum (20). Im umgekehrten Fall und bei gleichen Feuchte-Gehalten bleiben die Zungen (27) bzw. das zweite Schaltelement (19) geschlossen. Eine sinnvolle Differenz zwischen Innenfeuchtigkeit und Außenfeuchtigkeit führt somit zu einer Biegeverformung der Vielzahl der Zungen (27) in Richtung des der Gitterfolie (28) abgewandten Außenraums (20) und gibt eine Vielzahl der Konturen der Zungen (27) entsprechenden Öffnungen (30) frei. Die Zungen (27) können durch Stanzen als U-förmige Zunge (36), Λ-förmige Zunge (37) (Figur 10) oder Ω-förmige Zunge (38) (Figur 11) ausgeschnitten sein, so daß Zungen (36,37,38) entstehen, die an einem Ende mit dem Folienstück (26) verbunden bleiben und relativ zu ihrem individuellen Ausschnitt fixiert sind. Der jeweils freigebbare zweite Querschnitt A (21) ist eine Funktion von der Differenz der Feuchte (ΔF) und der Differenz der Drücke (Δp) auf beiden Seiten des zweiten Schaltelementes (19) (A=f(ΔF,Δp) ). Der freigebbare Querschnitt A setzt sich aus dem Produkt von einem feuchtigkeitsbezogenen Flächenfaktor a _{Δ F} und Differenz der Feuchte (ΔF) und aus einem Produkt von einem druckbezogenen Flächenfaktor a_{Δp} zusammen.
Damit gilt: A=f(ΔF,Δp)= a_{ΔF}•ΔF+ a_{Δp}•Δp. Im Falle einer Λ-förmigen Zunge (37) gilt: |a_{ΔF}| >> |a_{Δp}| und im Falle einer Ω-förmigen Zunge (38) gilt: |a_{ΔF}| << |a_{Δp}|.

Wird durch eine geeignete Gestaltung der Anströmbereiche beider Zungenseiten erreicht, daß in der direkten Umgebung der Zungenoberflächen beide Gasräume (2,20) das gleiche Temperaturniveau zeigen, korreliert die Verbiegung der Zungen (22,27) mit der Differenz der absoluten Feuchtegehalte der beiden Gasräume (2,20).

Alternativ kann das zweite Schaltelement (19) auch als eine einzige großflächige Zunge ausgebildet sein. Diese ist insbesondere für eine Ausführungsform bestehend aus einer einzigen Gehäuseöffnung geeignet.

Durch Abstimmung der Zungen (16,22,27, 37, 38) hinsichtlich Form und Abmessungen (Kontur und Dicke) auf die betriebstypischen Druckdifferenzen zwischen den Gasräumen (2,20) ist den Feuchte- und ggf. Temperatur-Schaltcharakteristiken eine Differenzdruck-Schaltcharakteristik überlagerbar.

Die beschriebenen Schaltelemente (10,19) sind im "geschlossenen" Zustand nicht vollständig dicht, sondern der freie Strömungsquerschnitt (9,9') wird auf ein endliches Minimum reduziert. Je nach Ausführungsform sind Querschnitts-Verhältnisse bis 1:1000 (geschlossen:geöffnet) realisierbar.

Die Schaltelemente (10,19) werden in runden oder rechteckigen Folienstücken (2 bis 5 cm²) mit zungenförmigen Ausstanzungen (16,22,27) versehen. Beim Gerätezusammenbau sind diese Folienstücke auf einen rahmenförmigen Träger appliziert (geklebt oder geschweißt), mit dem diese Vormontagegruppe im Gehäuse (1) befestigt (eingeschnappt oder Hotmelt-geklebt) wird. Die Folienstücke können aber auch einseitig an ihrer Kontur mit einem Haftkleber beschichtet und als Bandware (wie Etiketten) angeliefert und direkt in das Gehäuse (1) geklebt werden.

Ab einem bestimmten Grenzwert der Feuchtigkeit der Luft im Gehäuseinnenraum (2) des Gehäuses (1), d.h. wenn Betauung vorhanden ist, öffnet das erste Schaltelement (10), das der Luftaustrittsöffnung (4) vorgelagert ist und gibt den Strömungsquerschnitt (9) frei bzw. vergrößert ihn. Es wird somit die "Notwendigkeit" einer Durchlüftung erkannt. Überschreitet die Differenz von Innenfeuchtigkeit (Feuchtigkeit der Luft im Gehäuseinnenraum (2)) und Außenfeuchtigkeit der eintretenden Luft bzw. der Außenluftzirkulation (7) einen bestimmten Grenzwert, öffnet auch das der Lufteintrittsöffnung (3) zum Gehäuseinnenraum (2) hin vorgelagerte zweite Schaltelement (19) und gibt den Strömungsquerschnitt (9') frei bzw. vergrößert ihn. Somit kann Luft mit niedrigerer Luftfeuchte als der Luftfeuchte der Innenluft des Gehäuseinnenraumes (2) über die Außenluftzirkulation (7) durch die Lufteintrittsöffnung (3) in den Gehäuseinnenraum (2) eintreten, über die Innenluftzirkulation (8) die Betauung abbauen und über die Luftaustrittsöffnung (4) mit höherer Luftfeuchte wieder austreten. Es findet somit eine Durchlüftung und mit deren Hilfe eine Enttauung statt.

Ist die Außenfeuchtigkeit größer als die Innenfeuchtigkeit, öffnet das zweite Schaltelement (19) nicht und es findet statt einer Durchlüftung nur eine Belüftung statt. Eine Durchlüftung wäre in diesem Fall auch nicht sinnvoll, da durch Einbringen von Luft mit größerer Feuchte die Innenfeuchte und somit die Betauung unerwünscht vergrößert werden würde. Eine Enttauung könnte in diesem Fall gar nicht stattfinden.

Die Erfindung findet Anwendung auf jegliche Gehäuse, beispielsweise auch elektronische Bauelemente enthaltende Gehäuse. Unter Gehäuse sind auch Gebäude zu verstehen, die mit frischer, trockener Außenluft belüftet werden.

## Patentansprüche

1. Gehäuse, insbesondere eines Fahrzeugscheinwerfers, mit einer Durchlüftung eines Gehäuseinnenraumes über mindestens eine Öffnung (3, 4) für den Eintritt und/oder Austritt von Luftströmungen wobei in der Öffnung (3, 4) ein einen Strömungsquerschnitt (9, 9') in Abhängigkeit von Luftfeuchte veränderndes Schaltelement (10, 19) angeordnet ist, das selbstätig von einer Schließposition in eine Öffnungsposition und vice versa bewegbar ist, **dadurch gekennzeichnet, dass** der Strömungsquerschnitt (9, 9') mindestens einer der Öffnungen (3, 4) durch das Schaltelement (10, 19) in Abhängigkeit eines Differenzwertes aus einer Innenfeuchtigkeit des Gehäuseinnenraumes (2) und aus einer Außenfeuchtigkeit des außerhalb des Gehäuseinnenraumes (2) liegenden Außenraumes (20) veränderbar ist.

2. Gehäuse nach Anspruch 1, **dadurch gekennzeichnet, dass** das Schaltelement (10, 19) als eine einen Querschnitt (21) verändernde Zunge (22) ausgebildet ist, die aus zwei durch eine Diffusionssperre (23) von einander getrennten Lagen (24, 25) mit Feuchte-Dehneigenschaften so aufgebaut ist, dass eine Differenz zwischen Innenfeuchtigkeit und Außenfeuchtigkeit zu einer Biegeverformung führt, die den Querschnitt (21) vergrößert bzw. verkleinert.

3. Gehäuse nach Anspruch 1 oder 2, **dadurch gekennzeichnet, dass** das Schaltelement (19) als ein einen Querschnitt (21') verschließbares Folienstück (26) mit Feuchte-Dehneigenschaften und einer Vielzahl von ausgeschnittenen Zungen (27) ausgebildet ist, das auf seiner dem Innenraum (20) zugewandten Seite ein Führungselement (28) aufweist und so aufgebaut ist, dass eine Differenz zwischen Innenfeuchtigkeit und Außenfeuchtigkeit zu einer Biegeverformung der Vielzahl der Zungen (27) nur in Richtung des dem Führungselement (Gitterfolie 28) abgewandten Außenraums (20) führt und eine Vielzahl von den Zungenkonturen der Zungen (27) entsprechenden Zungenöffnungen (30) freigibt.

4. Gehäuse nach einem der Ansprüche 1 bis 3, **dadurch gekennzeichnet, dass** die Luftaustrittsöffnung (4) durch ein erstes Schaltelement (10) in Abhängigkeit von der Innenfeuchtigkeit und die Lufteintrittsöffnung (3) durch ein zweites Schaltelement (19) in Abhängigkeit des Differenzwertes aus der Innenfeuchtigkeit und der Außenfeuchtigkeit schaltbar ist.

5. Verfahren zur Durchlüftung eines Gehäuseinnenraumes eines Gehäuses, insbesondere eines Fahrzeugscheinwerfers, bei dem in den Gehäuseinnenraum über mindestens eine Lufteintrittsöffnung Luft eintritt und mindestens eine Luftaustrittsöffnung Luft austritt, **dadurch gekennzeichnet, dass** eine Durchlüftung nur dann erfolgt, wenn im Gehäuseinnenraum (2) eine Betauung vorhanden ist und wenn die Feuchtigkeit der eintretenden Luft kleiner ist als die Feuchtigkeit der Luft im Gehäuseinnenraum (2).

6. Verfahren nach Anspruch 5, **dadurch gekennzeichnet, dass** ein Strömungsquerschnitt (9') der Lufteintrittsöffnung (3) und/oder der Luftaustrittsöffnung (4) durch ein Schaltelement (19) in Abhängigkeit einer Differenz aus Außenfeuchtigkeit und Innenfeuchtigkeit der Luft verändert wird, und dass ein Strömungsquerschnitt (9) der Lufteintrittsöffnung (4) und/oder der Luftaustrittsöffnung (4) durch ein Schaltelement (10) in Abhängigkeit von der Innenfeuchtigkeit der Luft verändert wird.

## Claims

1. Housing, in particular for a vehicle headlamp, with ventilation of an interior housing area via at least one opening (3, 4) for inlet and/or outlet of airflows, and in the opening (3, 4) is arranged a switch element (10, 19) which changes a flow cross-section in dependence of air humidity and which is automatically movable from a shut position into an open position and vice versa, **characterised in that** the flow cross-section of at least one of the openings (3, 4) can be altered by the switch element (10, 19) in dependence of a value of difference of interior humidity of the interior housing area (2) and an exterior humidity of the environment area (20) outside the interior housing area (2).

2. Housing according to Claim 1, **characterised in that** the switch element (10, 19) is designed as a tongue (22) which alters a cross-section (21) and which is structured of two layers (24, 25) which are separated from each other by a diffusion lock (23) with humidity expansion properties so that a difference between interior humidity and exterior humidity results in a flexural deformation which increases or decreases the cross-section (21).

3. Housing according to Claim 1 or 2, **characterised in that** the switch element (19) is designed as a foil element (26) which seals a cross-section (21') with humidity-expansion properties and a plurality of cutout tongues (27), comprising on its side oriented towards the interior area (20) a guide element (28) and which is designed in such a manner that a difference between interior humidity and exterior humidity results in a flexural deformation of the plurality of tongues (27) only in the direction of the exterior area (20) facing away from the guide element (grid foil 28) and releases a plurality of tongue openings (30) which correspond with the tongue contours of the tongues (27).

4. Housing according to one of Claims 1 to 3, **characterised in that** the air outlet opening (4) is switchable by a first switch element (10) in dependence of the interior humidity, and the air inlet opening (3) is switchable by a second switch element (19) in dependence of the difference value of interior humidity and exterior humidity.

5. Method of ventilating the interior housing area of a housing, in particular a vehicle headlamp, with air entering the interior housing area via at least one air inlet opening and air exiting via at least one air outlet opening, **characterised in that** ventilation takes place only in the event of misting up in the interior housing area (2) and if the humidity of entering air is less than the humidity of the air in the interior housing area (2).

6. Method according to Claim 5, **characterised in that** a flow cross-section (9') of the air inlet opening (3) and/or the air outlet opening (4) is altered by a switch element (19) in dependence of a difference between exterior humidity and interior humidity of the air, and a flow cross-section (9) of the air inlet opening (4) and/or the air outlet opening (4) is altered by a switch element (10) in dependence of the interior humidity of the air.

## Revendications

1. Boîtier, en particulier d'un phare de véhicule, comportant une aération d'un espace intérieur de boîtier via au moins une ouverture (3, 4) pour l'entrée et/ou la sortie d'écoulements d'air, dans l'ouverture (3, 4) étant agencé un élément de commutation (10, 19) modifiant une section d'écoulement (9, 9') en fonction de l'humidité de l'air, lequel élément de commutation étant déplaçable automatiquement depuis une position de fermeture jusque dans une position d'ouverture et vice versa, **caractérisé en ce que** la section d'écoulement (9, 9') d'au moins une des ouvertures (3, 4) peut être modifiée par l'élément de commutation (10, 19) en fonction d'une valeur différentielle entre une humidité intérieure de l'espace intérieur du boîtier (2) et une humidité extérieure de l'espace extérieur (20) situé en dehors de l'espace intérieur du boîtier (2).

2. Boîtier selon la revendication 1, **caractérisé en ce que** l'élément de commutation (10, 19) est réalisé sous forme de languette (22) modifiant une section (21), laquelle est constituée par deux couches (24, 25) séparées l'une de l'autre par une barrière de diffusion (23) et possédant des propriétés d'extensibilité à l'humidité telles qu'une différence entre l'humidité intérieure et l'humidité extérieure entraîne une déformation par flexion qui agrandit ou diminue la section (21).

3. Boîtier selon l'une ou l'autre des revendications 1 et 2, **caractérisé en ce que** l'élément de commutation (19) est réalisé sous forme d'une pièce en feuille (26) fermant une section (21'), avec propriétés d'extensibilité à l'humidité et avec une multitude de languettes (27) découpées, laquelle présente un élément de guidage (28) sur sa face tournée vers l'espace intérieur (20), et qui a une structure telle qu'une différence entre l'humidité intérieure et l'humidité extérieure entraîne une déformation par flexion de la multitude de languettes (27) seulement en direction de l'espace extérieur (20) détourné de l'élément de guidage (feuille grillagée 28) et libère une multitude d'ouvertures pour languettes (30) correspondant aux contours des languettes (27).

4. Boîtier selon l'une des revendications 1 à 3, **caractérisé en ce que** l'orifice de sortie d'air (4) peut être commuté par un premier élément de commutation (10) en fonction de l'humidité intérieure et l'orifice d'entrée d'air (3) peut être commuté par un deuxième élément de commutation (19) en fonction de la valeur différentielle entre l'humidité intérieure et l'humidité extérieure.

5. Procédé d'aération de l'espace intérieur d'un boîtier, en particulier d'un phare de véhicule, dans lequel de l'air pénètre dans l'espace intérieur du boîtier via au moins un orifice d'entrée d'air et en sort via au moins un orifice de sortie d'air, **caractérisé en ce qu'**il ne se produit une aération que si dans l'espace intérieur de boîtier (2) existe une condensation d'humidité et si l'humidité de l'air entrant est inférieure à l'humidité de l'air dans l'espace intérieur du boîtier (2).

6. Procédé selon la revendication 5, **caractérisé en ce qu'**une section d'écoulement (9') de l'orifice d'entrée d'air (3) et/ou de l'orifice de sortie d'air (4) est modifiée par un élément de commutation (19) en fonction d'une différence entre l'humidité extérieure et l'humidité intérieure, et **en ce qu'**une section d'écoulement (9) de l'orifice d'entrée d'air (3) et/ou l'orifice de sortie d'air (4) est modifiée par un élément de commutation (10) en fonction de l'humidité de l'air à l'intérieur.
